# DEMANDE DE BREVET EUROPEEN

(11) **EP 3 432 079 A1**
(43) Date de publication de la demande: **23.01.2019**
(21) Numéro de dépôt: 18181622.4
(22) Date de dépôt: 04.07.2018
(51) Int. Cl.: G04B 15/14, G04B 17/06, G04B 43/00, C22C 9/06, C22C 19/05, C22C 30/02

(54) **COMPOSANT HORLOGER EN ALLIAGE BINAIRE CUNI AMAGNÉTIQUE**

(30) Priorité: 12.07.2017 CH 9062017
(71) Demandeur: Société anonyme de la Manufacture d'Horlogerie Audemars Piguet & Cie, 1348 Le Brassus (CH)
(72) Inventeur: GUADALUPE MALDONADO, Sandra, 1143 Apples (CH); NIARITSIRY, Tiavina, 1347 Le Sentier (CH); PHILIPPE, Laeticia, 3012 Berne (CH); FRANTZ, Cédric, 3613 Steffisburg (CH)
(74) Mandataire: Sammer, Thomas

(57) **Abrégé**

La présente invention propose un composant horloger monolithique, constitué d'un alliage binaire CuNi amagnétique, ledit composant étant obtenu par un procédé comprenant la réalisation d'un moule dudit composant par photolithographie et une étape d'électrodéposition.

Le procédé de fabrication du composant horloger monolithique est choisi parmi les procédés de type UV-LiGA.

## Description

### Domaine de l'invention

La présente invention a pour objet un composant horloger monolithique.

Par composant horloger monolithique au sens de la présente invention, on entend un composant fait d'une seule pièce, destiné à être incorporé dans une pièce d'horlogerie, telles que montres et chronomètres. Ce genre de composants est utilisé notamment dans le domaine des montres mécaniques.

### État de l'art antérieur

Pour obtenir des performances optimales de pièces clés pour la chronométrie telles qu'un spiral, un balancier ou une roue d'échappement, il est important de s'affranchir autant que possible des effets du magnétisme. Une solution très partielle peut consister en l'utilisation de blindages magnétiques à l'aide de matériaux attirant les lignes de champ magnétique et les déviant des composants sensibles.

Une autre solution actuelle est l'utilisation du silicium, en particulier pour le spiral. Ce matériau, performant dans cette application, n'était pas utilisé dans l'art horloger traditionnel. L'utilisation de ce matériau n'est toutefois pas exempt de problèmes: étant anisotrope, il peut présenter des variations du module de Young selon la direction des cristaux. Un autre défaut demeure son comportement cassant, lié à sa grande dureté.

D'autres composants horlogers ont été réalisés par exemple en Elinvar, avec d'autres alliages ternaires, par exemple FeNiCr, ou avec d'autres matériaux non magnétiques à base de fer, tels que des alliages FeCrNiMnBe comme le propose le document CH 711 913.

Ainsi, le document GB 1,156,574 propose la fabrication de ressorts horlogers à faible coefficient thermique en un alliage non magnétique à base de FeNiCr, avec des composants mineurs additionnels. Ce document ne divulgue pas la méthode de fabrication de cet alliage ni la méthode de formage d'un tel ressort. Ce document ne propose donc pas de solution pour la réalisation de composants horlogers de très petite taille.

Le document EP 2 487 547, qui a pour objet un régulateur de mobiles horlogers incorporant de nombreux composants faits de matériaux différents, mentionne un ressort en matériau non magnétique de type FeNiCr, dont le module d'élasticité varie peu en fonction de la température, réalisable par une technique LiGA (Lithographie, Galvanoformung, Abformung).

Le document US 2004/0154925 décrit la fabrication de MEMS (micro-electro-mechanical systems) par dépôt électrolytique de matériaux composites constitués d'alliages chargés en nanoparticules, en particulier d'alliages NiCu, Ni étant majoritaire, chargés d'alumine, dans des structures creuses de profondeurs comprises entre 10 et 2000 microns. Ces structures creuses sont réalisées par un procédé X-LiGA.

Plusieurs documents de l'art antérieur proposent l'utilisation des alliages binaires nickel-phosphore (NiP) pour la réalisation de composants horlogers. Toutefois, le document CH 705 680 rappelle que la technologie LiGA est employée dans le domaine horloger pour la fabrication de composants en alliages nickel-phosphore, mais peut conduire à des pièces présentant des défauts de résistance à l'usure. Il décrit un procédé d'amélioration de la dureté de certaines zones spécifiques d'un composant réalisé en un alliage NiP12, au moyen d'une étape de recuit.

De nombreux documents de l'art antérieur ont pour objet des traitements de surface de pièces en métal, céramique ou plastique, par dépôts de couches minces CuNi de l'ordre de la dizaine de microns. Ces traitements sont destinés à augmenter la résistance à la corrosion de ces pièces ou ont un but décoratif. À titre d'exemple, le brevet européen EP 2 840 169 décrit un bain de galvanisation à six composantes, comprenant des sels de Ni et de Cu ainsi que des additifs destinés à densifier les couches, ce bain présentant une excellente stabilité chimique, permettant d'abaisser le coût du procédé industriel de galvanisation.

Le document EP 3 098 670 décrit des composants d'habillage interne de montres, par exemple des appliques ou des index, obtenus par usinage mécanique d'un alliage à base de cuivre, majoritaire, de nickel et d'un autre composant tel que Mn, Al, Zr, présent en faibles proportions.

Dans les documents CH 712 718, CH 712 719, CH 712 760 et CH 712 762, tous publiés le 31 Janvier 2018, le déposant propose de réaliser un axe de pivotement de composant horloger par usinage mécanique, en un alliage amagnétique choisi parmi les alliages austénitiques, les alliages de cuivre tels que les bronzes, les cupronickels, CuBe, etc., et de durcir la surface de l'axe soit par un dépôt galvanique de NiB ou NiP, soit par diffusion d'heteroatomes, par exemple de bore, à partir de la surface de l'axe jusqu'à une profondeur déterminée. Du fait de l'étape de durcissement, ces composants ont des structures hétérogènes.

### Objectifs de l'invention

Le but de la présente invention est de remédier aux inconvénients des composants horlogers et méthodes de fabrication de l'état de la technique, et notamment de permettre la réalisation de composants horlogers monolithiques non-magnétiques avec une grande liberté de conception au niveau des formes.

Un autre but est la réalisation de tels composants qui soient homogènes et isotropes.

Un autre but est la réalisation de composants ayant un module de Young élevé, en particulier un module de Young présentant une faible variation thermique.

### Solution selon l'invention

A cet effet, la présente invention propose, sous un premier aspect, un composant horloger monolithique constitué d'un alliage binaire CuNi amagnétique, ledit composant étant obtenu par un procédé comprenant la réalisation d'un moule dudit composant par photolithographie et une étape d'électrodéposition.

Par ces mesures, l'utilisateur dispose donc de pièces non-magnétiques faites d'un matériau homogène et isotrope, de structure cristalline uniforme. Les alliages binaires CuNi amagnétiques, alliages ne comprenant dans leur structure que les éléments Cu et Ni ainsi que les éventuelles impuretés techniquement inévitables, présentent une excellente résistance à la fatigue, ainsi qu'à la corrosion, provoquée par exemple par l'eau salée.

De plus, l'utilisateur dispose de pièces dont le module de Young n'est pas affecté par la direction des cristaux.

La réalisation de moules qui présentent une forme complémentaire, en creux, à celle des composants horlogers, par photolithographie, offre une grande liberté de conception au niveau des formes en 2D de ces composants horlogers.

La présente invention propose, sous un deuxième aspect, des composants horlogers monolithiques du genre susmentionné, obtenus par un procédé choisi parmi les procédés de type UV-LiGA. Ce type de procédé offre une grande sûreté de mise en oeuvre et nécessite un équipement technologique beaucoup moins lourd que d'autres procédés photolithographiques, par exemple la technologie X-LiGA.

Le procédé choisi dans le cadre de l'invention offre une grande latitude de variation des paramètres électrochimiques de l'électrodéposition pour améliorer les propriétés du matériau lors de sa croissance, en particulier pour obtenir une structure cristalline uniforme.

Par ces mesures, l'utilisateur peut donc disposer de composants horlogers non-magnétiques homogènes, c'est-à-dire dont les propriétés sont uniformes dans l'ensemble du matériau, et isotropes, c'est-à-dire dont les propriétés mécaniques sont identiques dans toutes les directions.

D'autres caractéristiques, ainsi que les avantages correspondants, ressortiront des revendications dépendantes, ainsi que de la description exposant ci-après l'invention plus en détail.

### Description brève des dessins

Les figures annexées représentent, à titre d'exemples, des formes d'exécution de l'invention.
La figure 1 montre des microphotographies d'alliages CuNi de l'état de la technique.
La figure 2 montre une microphotographie d'une coupe d'un alliage CuNi selon l'invention.
La figure 3 montre un diffractogramme de l'alliage selon la figure 2.
La figure 4 montre une roue d'échappement selon l'invention.
La figure 5 montre un ressort spiral selon l'invention.
La figure 6 est un tableau résumant les conditions opératoires de l'étape d'électrodéposition de deux alliages CuNi selon l'invention.
La figure 7 est un tableau montrant des variantes de composition de bains d'électrodéposition selon l'invention.

### Description détaillée de l'invention

L'invention sera maintenant décrite en détail en référence aux figures annexées illustrant, à titre d'exemple, plusieurs formes d'exécution de l'invention.

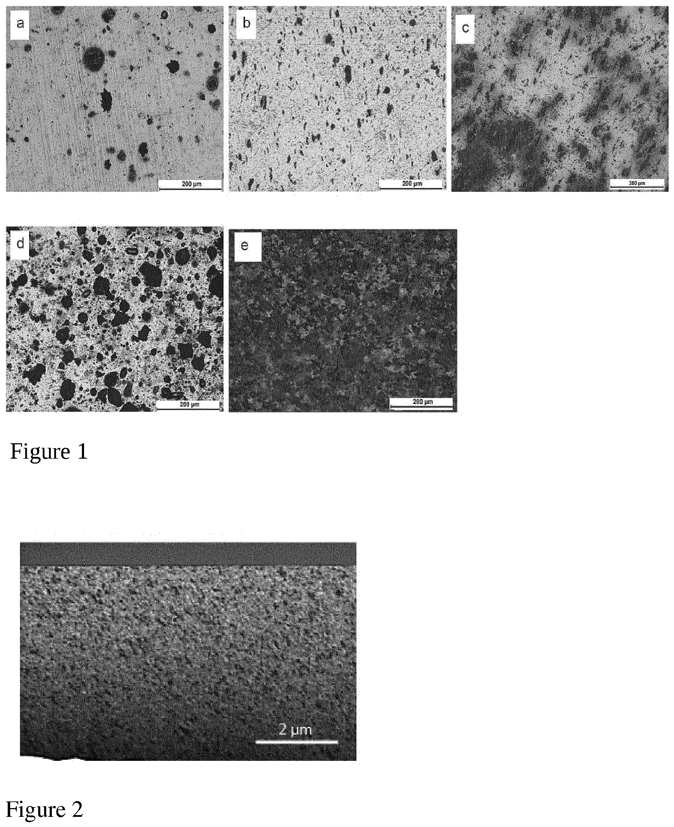

La figure 1 reproduit des microphotographies de cinq alliages CuNi qui ont été préparés par un procédé de métallurgie standard, compression de poudres, suivi d'un frittage dans un four sous vide. Les cinq alliages ont été réalisés par ce moyen avec les compositions suivantes: Ni-5wt%Cu, Ni-10wt%Cu, Ni-20wt%Cu, Ni- 30wt%Cu et Ni-50wt%Cu. Les microphotographies montrées sur la figure 1 sont extraites de l'article "Metallurgically prepared NiCu alloys as cathode materials for hydrogen évolution reaction" par Kunchan Wang et Ming Xia, Materials Chemistry and Physics 186 (2017), pages 61 à 66. Elles montrent une hétérogénéité des microstructures, avec coexistence de deux phases localisées dans des domaines distincts.

La figure 2 montre une microphotographie d'une vue en coupe d'un alliage CuNi, réalisée par fraisage ionique et microscopie ionique d'une section d'une pièce obtenue par électrodéposition suivant un procédé LiGA, selon l'invention. Sur la figure 2, on observe une microstructure de l'alliage caractérisée par une distribution uniforme de grains nanocristallins.

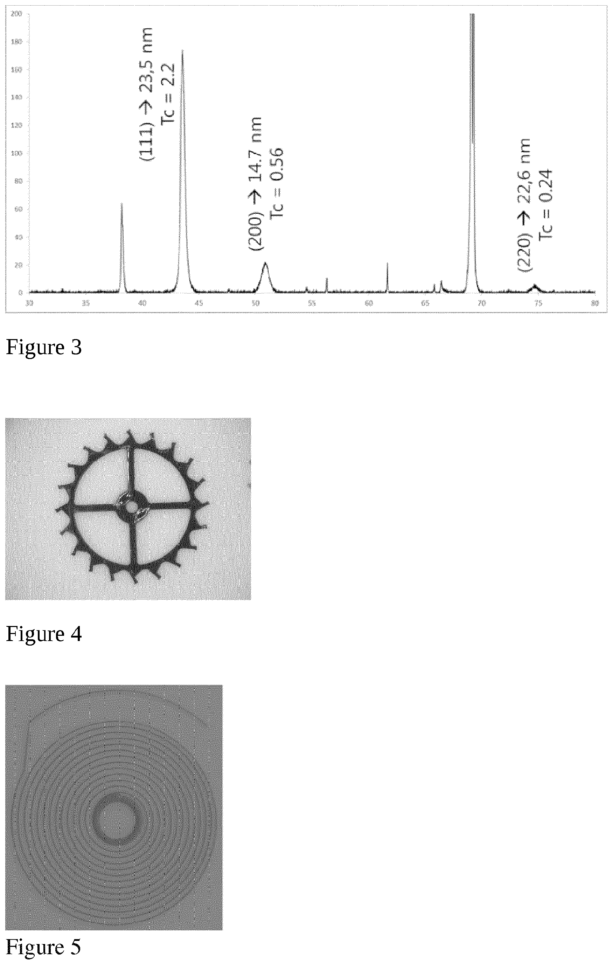

L'alliage montré à la figure 2 a été soumis à des analyses par diffractométrie de rayons-X (XRD). Le diffractogramme XRD est montré dans la figure 3; la taille des grains a été évaluée par l'équation de Scherrer, ainsi que les coefficients de texture associés à chaque plan cristallographique. Ce diffractogramme montre un grand pic dans l'orientation (111), ce qui indique la formation de dépôts texturés, avec texture le long du plan {111}. Un tel pic n'est pas visible dans les diffractogrammes d'alliages obtenus par un procédé de métallurgie standard tel que ci-dessus.

Il en résulte qu'un alliage binaire CuNi obtenu par un procédé d'électrodéposition selon l'invention a une microstructure métallurgique différente de celle d'un alliage CuNi comprenant les composantes Cu et Ni dans les mêmes proportions, mais obtenu par un procédé de métallurgie standard.

Par conséquent, un composant horloger monolithique, constitué d'un alliage binaire CuNi amagnétique obtenu par un procédé d'électrodéposition, a une structure métallurgique différente de celle qu'aurait un composant horloger de même forme obtenu par un procédé de métallurgie standard.

L'homme du métier sait que les composantes Cu et Ni sont miscibles en toutes proportions pour former des alliages binaires, les propriétés magnétiques des alliages étant fonction de ces proportions. Ces alliages présentent des propriétés de type ferromagnétique lorsque la proportion de Ni est supérieure à environ 60% en masse.

Les composants monolithiques constitués d'un alliage binaire CuNi obtenu par électrodéposition, au sens le plus général de la présente invention, sont ceux qui, de par les proportions des composantes Cu et Ni, sont amagnétiques.

En particulier, les composants horlogers monolithiques selon l'invention sont constitués d'un alliage binaire Cu(x) Ni(100-x), avec 45 < x < 80, où x désigne le pourcentage atomique de cuivre. Plus spécifiquement, les composants horlogers monolithiques selon l'invention sont constitués d'un alliage binaire Cu(x) Ni(100-x), avec 55 < x < 75. En particulier, si x vaut environ 55, où x désigne le pourcentage atomique de cuivre, l'alliage présente une variation thermique minimale des propriétés mécaniques aux températures ambiantes usuelles.

Les composants horlogers monolithiques selon l'invention sont obtenus, de préférence, à partir d'un bain d'électrodéposition comprenant au moins un sel de Ni²⁺ et un sel de Cu²⁺, les cations Ni²⁺ étant en excès par rapport aux Cu²⁺ de telle sorte que la réduction de Ni²⁺ est contrôlée par la cinétique alors que la réduction de Cu²⁺ est limitée par le transfert de masse.

Ledit bain d'électrodéposition peut en particulier comprendre un sel de Ni²⁺ à une concentration de 0,1 M à 0,4 M, et un sel de Cu²⁺ à une concentration 0,04 M à 0,1 M, lesdites concentrations étant ajustées de façon à obtenir une valeur x prédéterminée.

Le bain peut être réalisé en utilisant le sulfate de Cu, en particulier à une concentration 0,08 M et le sulfate de Ni, en particulier à une concentration de 0,2 M ou 0,3 M. Le bain peut également être réalisé en utilisant le sulfamate de Ni, en particulier à une concentration de 0,2 M, et un sel de Cu choisi parmi le sulfate, le chlorure, le citrate ou le sulfamate à une concentration appropriée de 0,01 M à 0,1 M. D'autres sels de Ni et de Cu peuvent être utilisés sans sortir du cadre de l'invention.

Le bain d'électrodéposition comprend, de préférence, un agent chélatant, pour les ions Cu²⁺, en particulier du citrate de Na à une concentration de 0,1 M à 0,2 M, et le pH du bain est ajusté à une valeur de 6, par exemple au moyen de NaOH ou H₂SO₄.

Le bain d'électrodéposition comprend, de préférence, des additifs, choisis parmi les agents mouillants, les agents d'écoulement et les agents densifiants, par exemple 1 g/L de saccharine, 2 ml/L de PC-3 et 1 ml/L de Wetting W (additifs commercialisés par A-GAS International).

Comme mentionné plus haut, le procédé de fabrication d'un composant horloger monolithique selon l'invention est choisi parmi les procédés de type UV-LiGA. Ledit procédé met en oeuvre un substrat de lithographie, qui sert de cathode pendant l'étape d'électrodéposition, en particulier un wafer Au/Cr/Si et une résine photorésistante, par exemple de type SU-8 (produits commerciaux). Le principe et les caractéristiques générales de la technologie LiGA sont connus de l'homme du métier et ne seront donc pas exposés ici. Seules les caractéristiques spécifiques destinées à la réalisation des composants horlogers selon l'invention sont exposées ci-dessous.

Plusieurs mesures pour améliorer la qualité du dépôt, notamment son homogénéité, d'où résulte l'homogénéité du composant horloger, peuvent être mises en oeuvre indépendamment ou simultanément:
Le substrat ayant reçu son/ses impression(s) peut être exposé à un plasma O₂ avant l'étape d'électrodéposition.

L'étape d'électrodéposition peut mettre en oeuvre une anode constituée d'un métal noble, par exemple Pt, agencée parallèlement à et en regard de la cathode, et, optionnellement, une électrode de référence.

De préférence, la température du bain d'électrodéposition est maintenue constante pendant l'électrodéposition, en particulier ajustée à 40°C, et son pH à 6.

Pour maintenir constante la composition du bain pendant le processus électrochimique, y compris dans les creusures du moule, l'électrodéposition est effectuée en courant pulsé, la durée des impulsions cathodiques étant ajustée entre 5 ms et 2 s, plus particulièrement entre 0,3 s et 1 s, les impulsions étant séparées par des pauses à courant nul pour permettre la relaxation de la couche de diffusion à la surface du dépôt. Pour réduire la durée de l'étape de dépôt, on préfère ajuster les pauses à une durée inférieure à 5 s, plus particulièrement 3 s.

Dans ce mode d'exécution, une densité de courant comprise entre -1 mA.cm⁻² et -200 mA.cm⁻² est appliquée pendant les impulsions cathodiques. Ou encore, un potentiel cathodique vis-à-vis d'une électrode Ag/AgCl, compris entre -0,8 V et -1,6 V est appliqué et maintenu pendant les impulsions.

De préférence, le processus d'électrodéposition est initié par une impulsion de nucléation avec un potentiel ajusté entre -0.8 V et -1.6 V vis-à-vis d'une électrode Ag/AgCl, ou une densité de courant ajustée entre -1 mA.cm⁻² et -200 mA.cm⁻².

En particulier, l'impulsion de nucléation peut être effectuée à -1 V vis-à-vis d'une électrode Ag/AgCl pendant 11 s. L'impulsion de nucléation peut être effectuée en mode galvanostatique à une densité de courant moitié de celle des impulsions suivantes.

De plus, le bain est avantageusement agité pendant l'électrodéposition. L'agitation permet d'augmenter la densité de courant, d'où un processus plus rapide. En effet, les inventeurs ont constaté que dans un même dispositif expérimental
- la densité de courant peut être ajustée à environ -390 mA.cm⁻² par mole/L de Cu^{II} en l'absence d'agitation,
- la densité de courant peut être ajustée à environ -830 mA.cm⁻² par mole/L de Cu" sous agitation de 150 rpm,
- la densité de courant peut être ajustée à environ -1.3 A.cm⁻² par mole/L de Cu" sous agitation de 300 rpm,
- un potentiel cathodique de -1.3 V vis-à-vis d'une électrode Ag/AgCl peut être appliqué sous agitation de 300 rpm.

En fin de processus d'électrodéposition
- celui-ci est poursuivi jusqu'à ce que l'épaisseur du dépôt dépasse l'épaisseur de la couche de résine,
- la surépaisseur du dépôt par rapport à l'épaisseur de consigne du composant horloger est éliminée par polissage,
- la résine est éliminée par voie physicochimique, par exemple au moyen d'un plasma O₂ si la résine est du type SU-8,
- le composant horloger est détaché du substrat, en particulier par dissolution d'au moins la couche superficielle de ce dernier, par exemple avec 1.5 M KOH à 80°C.

### Exemples

### Exemple 1: Ressort spiral

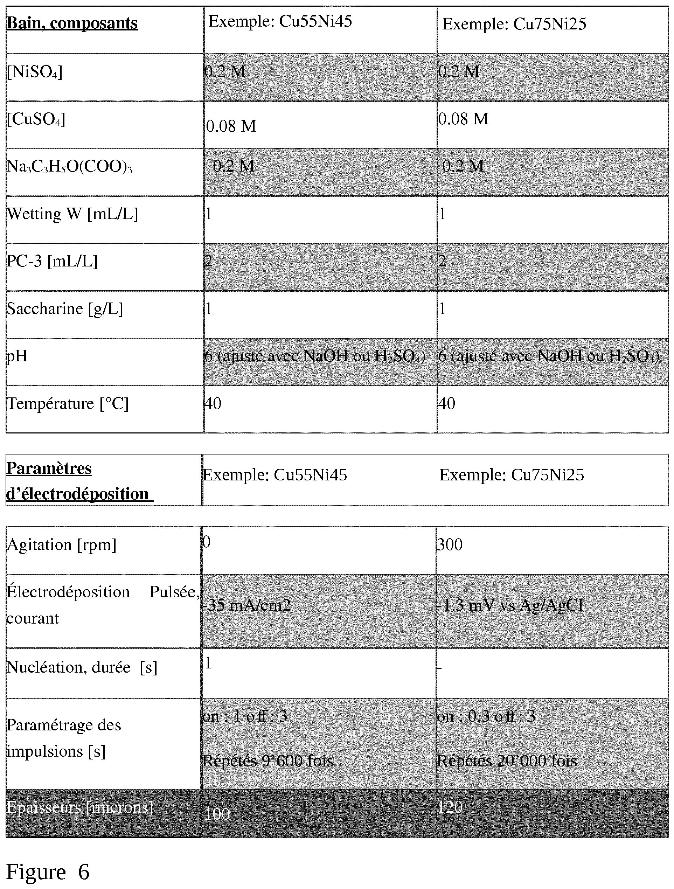

Le ressort spiral montré sur la figure 5 a été réalisé en alliage Cu(55)Ni(45) par procédé LiGA comme exposé ci-dessus, avec les paramètres opératoires de la colonne de gauche du tableau de la figure 6.

La pièce obtenue présente les propriétés mécaniques suivantes:

| | |
|---|---|
| - Module de Young: | 110 ± 10 G Pa |
| - Dureté: | 2,40 ± 0,13 G Pa |
| - Fréquence de fonctionnement: | 2 Hz |
| - Amplitude: | 217 ° - 268 ° (en moyenne, en 6 positions). |

### Exemple 2: Roue d'échappement

La roue d'échappement montrée sur la figure 4 a été réalisée en alliage Cu(75)Ni(25) par procédé LiGA comme exposé ci-dessus, avec les paramètres opératoires de la colonne de droite du tableau de la figure 6.

### Exemple 3: Bains d'électrodéposition

La figure 6 montre des compositions de bains préparés au moyen de sulfates de Ni et de Cu.

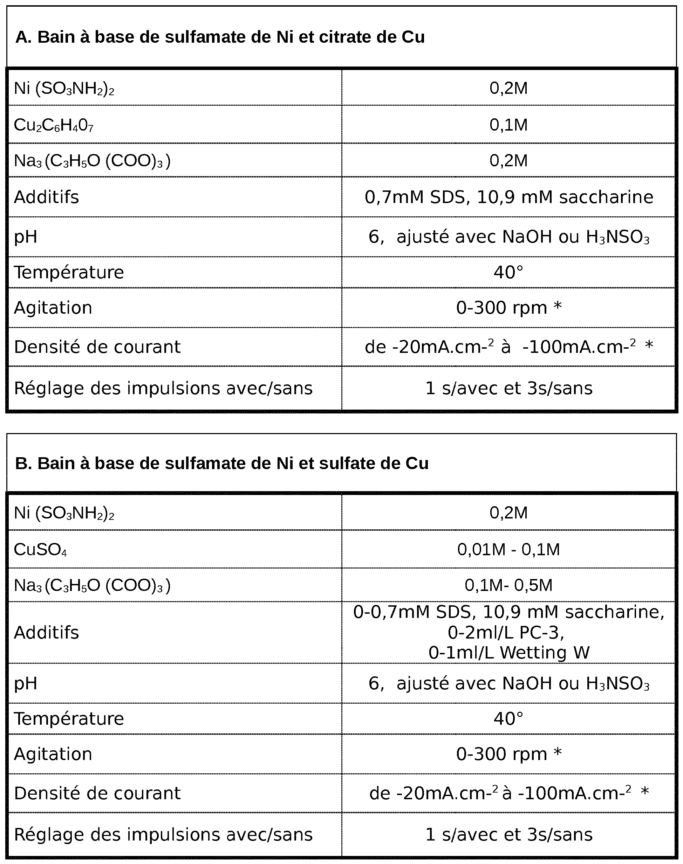

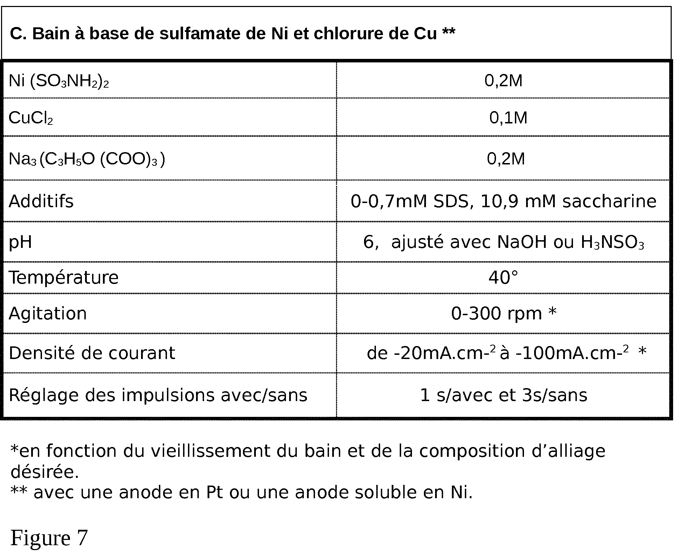

Le tableau de la figure 7 montre 3 exemples de compositions de bains préparés au moyen de sulfamate de Ni et, respectivement, de citrate, de sulfate et de chlorure de Cu.

Au vu des explications ci-dessus ayant trait à la structure et au procédé de fabrication des composants horlogers selon la présente invention, il est manifeste qu'un tel composant horloger procure de nombreux avantages et permet d'atteindre les buts énoncés dans l'introduction. Il convient de souligner en particulier que la forme géométrique en 2D d'un tel composant peut être choisie avec une liberté quasi totale par l'horloger concepteur. Le choix des composantes Ni et Cu de l'alliage binaire, entièrement miscibles, permet une grande liberté de sélection des concentrations relatives de ces deux espèces en fonction des contraintes imposées au produit fini.

## Revendications

1. Composant horloger monolithique, constitué d'un alliage binaire CuNi amagnétique, ledit composant étant obtenu par un procédé comprenant la réalisation d'un moule dudit composant par photolithographie et une étape d'électrodéposition.

2. Composant horloger monolithique selon la revendication 1, **caractérisé en ce que** ledit composant est un composant de mouvement d'horlogerie.

3. Composant horloger monolithique selon la revendication 1 ou la revendication 2, **caractérisé en ce que** ledit composant est homogène et isotrope.

4. Composant horloger monolithique selon l'une des revendications 1 à 3, constitué d'un alliage binaire Cu(x) Ni(100-x), avec 45 < x < 80, où x désigne le pourcentage atomique de cuivre.

5. Composant horloger monolithique selon l'une des revendications 1 à 4, constitué d'un alliage binaire Cu(x) Ni(100-x), avec 55 < x < 75, en particulier x = 55, où x désigne le pourcentage atomique de cuivre.

6. Composant horloger monolithique selon l'une des revendications 1 à 5, **caractérisé en ce que** ledit alliage binaire CuNi est obtenu à partir d'un bain d'électrodéposition comprenant au moins un sel de Ni²⁺ et un sel de Cu²⁺, les cations Ni²⁺ étant en excès par rapport aux Cu²⁺ de telle sorte que la réduction de Ni²⁺ est contrôlée par la cinétique alors que la réduction de Cu²⁺ est limitée par le transfert de masse.

7. Composant horloger monolithique selon la revendication 6, **caractérisé en ce que** ledit bain d'électrodéposition comprend un sel de Ni²⁺ à une concentration de 0,1 M à 0,4 M, en particulier de 0,2 M à 0,3 M, et un sel de Cu²⁺ à une concentration 0,04 M à 0,1 M, en particulier 0,08 M, lesdites concentrations étant ajustées de façon à obtenir une valeur x prédéterminée.

8. Composant horloger monolithique selon l'une des revendications 6 ou 7, **caractérisé en ce que** ledit bain d'électrodéposition comprend de plus un agent chélatant des ions Cu²⁺, en particulier du citrate de Na, et que le pH du bain est ajusté une valeur de 6.

9. Composant horloger monolithique selon l'une des revendications 6 à 8, **caractérisé en ce que** ledit bain d'électrodéposition comprend de plus des additifs choisis parmi les agents mouillants, les agents brillanteurs, les agents nivelants et les agents suppresseurs de stress.

10. Composant horloger monolithique selon l'une des revendications précédentes, obtenu par un procédé choisi parmi les procédés de type UV-LiGA.

11. Composant horloger monolithique selon la revendication 10, **caractérisé en ce que** ledit procédé de type UV-LiGA met en oeuvre un substrat de lithographie Au/Cr/Si et une résine photo-résistante de type SU-8, que ledit substrat est exposé à un plasma O₂ avant l'étape d'électrodéposition et que ledit substrat sert de cathode pendant l'étape d'électrodéposition.

12. Composant horloger monolithique selon la revendication 11, **caractérisé en ce que** l'électrodéposition met en oeuvre une anode constituée d'un métal noble, agencée parallèlement à et en regard de la cathode, et, optionnellement, une électrode de référence.

13. Composant horloger monolithique selon la revendication 12, **caractérisé en ce que** la température du bain d'électrodéposition est maintenue constante pendant l'électrodéposition, en particulier est ajustée à 40°C, et que le bain est agité pendant l'électrodéposition.

14. Composant horloger monolithique selon l'une des revendications 10 à 131, **caractérisé en ce que** l'électrodéposition est effectuée en courant pulsé, la durée des impulsions cathodiques étant ajustée entre 5 ms et 2 s, plus particulièrement entre 0,3 s et 1 s, les impulsions étant séparées par des pauses à courant nul.

15. Composant horloger monolithique selon la revendication 14, **caractérisé en ce qu'**un courant ajusté à une densité de courant comprise entre -1 mA.cm⁻² et -200 mA.cm⁻² est appliqué pendant les impulsions cathodiques.

16. Composant horloger monolithique selon la revendication 14 **caractérisé en ce qu'**un courant ajusté à un potentiel cathodique, vis-à-vis d'une électrode Ag/AgCl, compris entre -0.8 V et -1.6 V est appliqué pendant les impulsions.

17. Composant horloger monolithique selon l'une des revendications 14 à 16, **caractérisé en ce que** le processus d'électrodéposition est initié par une impulsion de nucléation avec un potentiel ajusté entre -0.8 V et -1.6 V vis-à-vis d'une électrode Ag/AgCl, ou une densité de courant ajustée entre -1 mA.cm⁻² et -200 mA.cm⁻².

18. Composant horloger monolithique selon la revendication 17, **caractérisé en ce que** l'impulsion de nucléation est effectuée à -1 V vis-à-vis d'une électrode Ag/AgCl pendant 11 s.

19. Composant horloger monolithique selon la revendication 17, **caractérisé en ce que** l'impulsion de nucléation est effectuée en mode galvanostatique à une densité de courant moitié de celle des impulsions suivantes.
